# EUROPÄISCHE PATENTANMELDUNG

(11) **EP 0 672 887 A1**
(43) Veröffentlichungstag der Anmeldung: **20.09.1995**
(21) Anmeldenummer: 95200525.4
(22) Anmeldetag: 03.03.1995
(51) Int. Cl.: G01B 7/004, G06K 11/16, A61C 19/045

(54) **Anordnung zur Bestimmung der räumlichen Position eines gegenüber einem Bezugselement verschiebbaren Abtastelements**

(30) Priorität: 09.03.1994 DE 4407785
(71) Anmelder: Philips Patentverwaltung GmbH, 22335 Hamburg (DE); Philips Electronics N.V., 5621 BA Eindhoven (NL)
(72) Erfinder: Fuchs, M., Dr., D-20097 Hamburg (DE)
(74) Vertreter: Hartmann, Heinrich, Dipl.-Ing.

(57) **Zusammenfassung**

Die Erfindung betrifft eine Anordnung zur Bestimmung der räumlichen Position eines gegenüber einem Bezugselement (1) räumlich verschiebbaren Abtastelements (3),
- mit drei im Abtastelement (3) angeordneten, aus mindestens einer Drahtwindung bestehenden Raum-Spulen (4,5,6) welche um einen gemeinsamen Mittelpunkt (7) gewickelt sind,
- mit mindestens drei im Bezugselement (1) an räumlich voneinander entfernten Stellen angeordneten, aus mindestens einer Drahtwindung bestehenden Bezugs-spulen (2),
- mit einem Stromgenerator (11) zur Erregung der Raum-Spulen (4,5,6) oder der Bezugs-Spulen (2) mit einem vorgebbaren Erreger-Wechselstrom,
- mit einer Auswerteschaltung (15) für die in den Bezugs-Spulen (2) bzw. in den Raum-Spulen (4,5,6) induzierten Spannungen, welche eine Rechenschaltung enthält, welche aus den induzierten Spannungen die Abstandskoordinaten xₘ, yₘ und zₘ des Mittelpunktes (7) der Raum-Spulen (4,5,6) in einem mit dem Bezugselement (1) verbundenen Koordinatensystem errechnet, sowie
- mit einer Rückkopplungsschaltung (13), welche in Abhängigkeit der Amplitude der induzierten Spannungen die Erregerströme steuert.

## Beschreibung

Die Erfindung betrifft eine Anordnung zur Bestimmung der räumlichen Position eines gegenüber einem Bezugselement räumlich verschiebbaren Abtastelements.

Eine derartige Anordnung zur Bestimmung der relativen Position und Orientierung zwischen einem Multikanal-MEG-Magnetometer und dem zu untersuchenden Kopf ist durch "Advances in Biomagnetism 1989, New York" bekannt. Die orthogonal zueinander und um einen gemeinsamen Mittelpunkt ausgerichteten Sendespulen werden am Kopf angeordnet und separat mit Strom gespeist. Das gebildete Magnetfeld wird mit einem 7-Kanal-Magnetometer gemessen. Der Lagevektor der am Kopf angeordneten Spulengruppe wird nach der Methode der kleinsten quadratischen Abweichungen (nonlinear least-squares fitting) ermittelt. Dabei wird aufgrund der Magnetometer-Meßwerte diejenige der möglichen Feldverteilungen gesucht, welche mit den jeweiligen Magnetometer-Meßwerten korrespondiert. Den für die einzelnen Sendespulen gefundenen Feldverteilungen können rechnerisch eindeutige Koordinatenwerte x_{m,} yₘ und zₘ zugeordnet werden.

Es läßt sich theoretisch nachweisen, daß es ausreichend ist, an nur drei verschiedenen Stellen jeweils die Felder der Sendespulen zu messen, um eindeutige Raumkoordinaten xₘ, yₘ und zₘ zu erhalten. Durch die Auswertung zusätzlicher, an weiteren Orten gemessener Feldwerte läßt sich die Genauigkeit erhöhen.

Will man zusätzlich die Winkelraumlage des Satzes der orthogonalen Spulen ermitteln, benötigt man mindestens an fünf verschiedenen Orten ermittelte Feldwerte. Eine Redundanz der Meßwerte erhöht wiederum die Genauigkeit der errechneten Koordinaten.

Die bekannte Anordnung erlaubt eine relativ genaue und rauscharme Koordinatenbestimmung, weil SQUID-Magnetometer mit supraleitenden Meßspulen verwendet werden.

Zur Erfassung der räumlichen Lage einer sogenannten Maus für Computer ist durch die DE-A 38 38 605 eine Anordnung mit von der Maus ausgestrahlten akustischen Wellen bekannt, welche an drei Meßpunkten eines Bezugssystems zur Abstandsmessung detektiert werden. Durch WO 90/07762 ist eine vergleichbare Anordnung bekannt, bei welcher statt akustischer Wellen bevorzugt optische Wellen Verwendung finden sollen.

Der Erfindung liegt die Aufgabe zugrunde, eine Anordnung der eingangs genannten Art zu schaffen, welche auf dem Prinzip der Messung magnetischer Feldverteilungen beruht und welche auch ohne supraleitende Meßspulen genügend genaue und rauscharme Ergebnisdaten liefert.

Die Lösung gelingt bei einer Anordnung der eingangs genannten Art
- mit drei im Abtastelement (3) angeordneten, aus mindestens einer Drahtwindung bestehenden Raum-Spulen (4,5,6), welche um einen gemeinsamen Mittelpunkt (7) gewickelt sind,
- mit mindestens drei im Bezugselement (1) an räumlich voneinander entfernten Stellen angeordneten, aus mindestens einer Drahtwindung bestehenden Bezugs-Spulen (2),
- mit einem Stromgenerator (11) zur Erregung der Raum-Spulen (4,5,6) oder der Bezugs-Spulen (2) mit einem vorgebbaren Erreger-Wechselstrom,
- mit einer Auswerteschaltung (15) für die in den Bezugs-Spulen (2) bzw. in den Raum-Spulen (4,5,6) induzierten Spannungen, welche eine Rechenschaltung enthält, welche aus den induzierten Spannungen die Abstandskoordinaten xₘ, yₘ und zₘ des Mittelpunktes (7) der Raum-Spulen (4,5,6) in einem mit dem Bezugselement (1) verbundenen Koordinatensystem errechnet, sowie
- mit einer Rückkopplungsschaltung (13), welche in Abhängigkeit der Amplitude der induzierten Spannungen die Erregerströme steuert.

Eine solche Anordnung kann insbesondere verwendet werden für
- die räumliche Lageermittlung einer Maus, insbesondere für dreidimensionale Zeiger (Cursor) im Falle von CAD-Programmen,
- das dreidimensionale Einlesen eines Objektes in einen Computer,
- die Lokalisierung von Objekten relativ zu einem Koordinatenursprung ganz allgemein und insbesondere in der medizinischen Meßtechnik.

Für die Erfindung wird von dem in "Advances in Biomagnetism" beschriebenen Meßprinzip Gebrauch gemacht. Dieses bekannte Meßprinzip läßt sich im Falle der vorliegenden Erfindung auch umkehren, indem die Raum-Spulen als Meßspulen verwendet werden, wobei dann die von den einzelnen Spulen des Bezugs-Systems erzeugten Magnetfelder detektiert werden.

Eine beträchtliche Genauigkeitssteigerung erreicht man durch die Rückkopplungsschaltung, welche dafür sorgt, daß den Raum-Spulen bei Vergrößerung ihres Abstands vom Bezugselement höhere Erregerströme zugeführt werden. Derart lassen sich Verstärker für die induzierten Spannungen optimal aussteuern. Der Meßdynamikbereich eines Verstärkers läßt sich etwa um den Faktor 1000 vergrößern.

In einer vorteilhaften Ausgestaltung der Erfindung sind die Wicklungsachsen der Raum-Spulen in zueinander senkrechten Richtungen angeordnet. Hierdurch vereinfachen sich die Bestimmungsgleichungen und verringern damit den erforderlichen Rechenaufwand.

Eine weitere Erhöhung der Meßgenauigkeit und des Rauschabstandes ist dadurch möglich, daß die induzierten Spannungen über einen frequenz- und/oder phasenempfindlichen, mit dem Stromgenerator gekoppelten Verstärker an die Auswerteschaltung angeschlossen sind.

Gemessen werden müssen die Feldverteilungen, die separat von jeder einzelnen Spule des Abtastelements bzw. des Bezugselements erzeugt werden. Das kann mit gleichfrequenten Erregerströmen geschehen, die zeitlich aufeinanderfolgend den einzelnen Spulen zugeschaltet werden, insbesondere mittels eines Multiplexers.

Es ist aber auch möglich, jede Erregerspule mit einem Strom zugeordneter unterschiedlicher Frequenz zu betreiben. Diese Ströme können dann gleichzeitig aufgeschaltet werden, da die entsprechenden induzierten Meßspannungen eindeutig selektierbar sind. Das letzgenannte Verfahren ist besonders schnell und ermöglicht in Verbindung mit schnellen Meßwerterfassungen und Lokalisierungsalgorithmen eine online-Ortsbestimmung mit weniger als einer Sekunde Meß- und Rechenzeit.

Die Erfindung wird nachstehend anhand der Zeichnung erläutert. Es zeigen:
- Fig. 1: eine Prinzipdarstellung einer Ausführungsform der Erfindung und
- Fig. 2: eine Anwendungsmöglichkeit in der Medizintechnik.

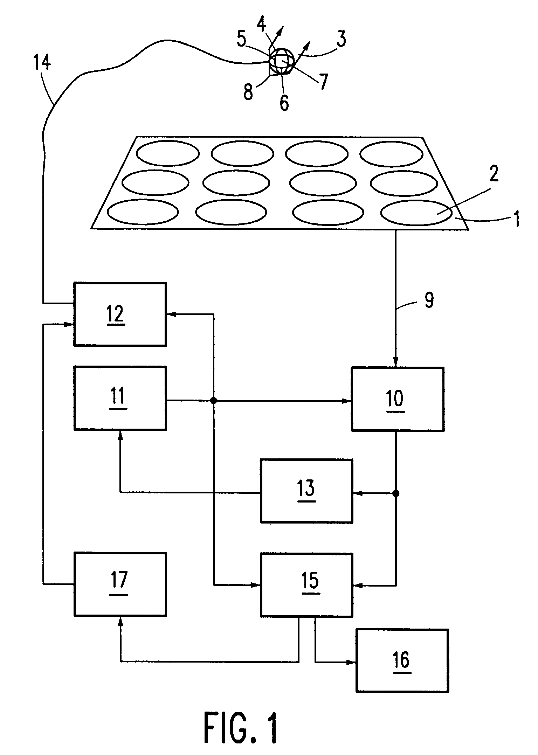

Mit 1 ist in Fig. 1 ein Empfangsspulentablett bezeichnet, welches als Bezugselement dient und an welchem zwölf aus mehreren Windungen bestehende Bezugs-Spulen 2 befestigt sind, welche im Beispiel als Meßspulen dienen, in welchen zu messende Wechselspannungen induziert werden. Das Empfangsspulentablett bildet zweckmäßig eine untere Begrenzungsebene des vom Abstandselement 3 zu erfassenden Raumes. Die Meßspulen 2 sind in möglichst großem Abstand zueinander anzuordnen und sollen sich bis an den äußeren Rand der Begrenzungsebene des Meßraumes erstrecken. Die Meßspulen brauchen jedoch nicht unbedingt in einer gemeinsamen Ebene angeordnet zu werden.

Die Raum-Spulen 4,5 und 6 dienen als Sendespulen, welche im Meßraum eine magnetische Feldverteilung hervorrufen. Sie sind in zueinander senkrechten, durch den gemeinsamen Mittelpunkt 7 verlaufenden Ebenen gewickelt.

Mit einer in der Figur dargestellten Anordnung können die Koordinaten xₘ, yₘ und zₘ des Mittelpunkts 7 in einem zum Empfangsspulentablett festgelegten Koordinatensystem ermittelt werden.

Falls die Position der Tastspitze 8 des Abstandselements 3 genau bekannt sein muß, können zusätzlich im Anschluß an die Berechnung der Koordinaten xₘ, yₘ und zₘ zwei Winkelkoordinaten in zwei orthogonalen, durch den Mittelpunkt 7 verlaufenden Ebenen ermittelt werden. Die Koordinaten xₘ, yₘ und zₘ lassen sich durch Auswertung der Summe der gemessenen Magnetfeldquadrate bereits eindeutig aus den von nur drei Meßspulen gelieferten Daten ermitteln. Dabei entfallen die funktionalen Abhängigkeiten von den Winkelkoordinaten. Wenn die dreidimensionalen Koordinaten ermittelt sind, vermag ein geeigneter Rechenalgorithmus bei Bedarf auch die Winkelkoordinaten zusätzlich zu ermitteln, da die dafür notwendige Voraussetzung, daß Meßwerte von mindestens fünf verschiedenen Meßstellen vorliegen, erfüllt ist. Wenn wie im vorliegenden Fall zwölf Meßspulen vorgesehen sind, ermöglicht die Redundanz eine erheblich größere Genauigkeit.

Die in den Meßspulen 2 induzierten Spannungen werden über das Leitungsbündel 9 an den Eingang des frequenz- und phasenempfindlichen Verstärkers 10 (lock in Verstärker) gelegt. Der Bereich der Phasen- und Frequenzselektivität des Verstärkers 10 wird durch die Frequenz und die Phasenlage des Stromgenerators 11 vorgegeben, welcher über den Multiplexer 12 die Sendespulen 4,5 und 6 zeitlich aufeinanderfolgend mit vorzugsweise jeweils gleicher Amperewindungszahl erregt.

Durch die Rückkopplungsschaltung 13 wird eine volle Ausnutzung des Dynamikbereichs des Verstärkers 10 bewirkt. Der Stromgenerator 11 wird veranlaßt, bei Vergrößerung des Abstandes des Abtastelements 3 vom Tablett 1 den über das Leitungsbündel 14 zu den Sendespulen 4,5 und 6 geleiteten Stroms soweit zu erhöhen, daß der Verstärker durch den höchsten Wert der in den Spulen 2 induzierten Spannungen gerade ausgesteuert ist.

Die Auswerteschaltung 15 erhält Informationen über die verstärkten induzierten Spannungen der Spulen 2, über die Zeitpunkte der Strombeaufschlagung der Sendespulen 4,5 und 6 sowie über die Höhe des Erregerstromes. Aufgrund dieser Daten wird mittels eines in der Auswerteschaltung 15 integrierten Rechenprogramms die Raumlage des Abtastelements durch Bestimmung der Koordinaten xₘ, yₘ und zₘ sowie gegebenenfalls zweier Winkelkoordinaten errechnet und an die Ausgabeeinheit 16 gegeben. Sobald an die Steuerschaltung 17 die Information übermittelt ist, daß der Rechen- und Ausgabevorgang beendet ist, erhält der Multiplexer einen Steuerbefehl, den Erregerstrom auf die nächstfolgende Sendespule zu schalten.

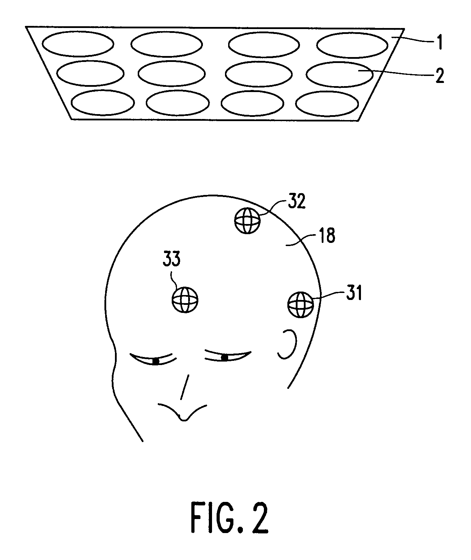

In Fig. 2 ist eine Anwendungsmöglichkeit der Erfindung auf dem Gebiet der Medizintechnik skizziert.

Drei Abstandselemente 31, 32 und 33, bestehend jeweils aus drei Raum-Spulen, werden an unterschiedlichen Stellen am Kopf 18 eines Patienten angebracht. Die Positionen der Abstandselemente 31,32 und 33 können mit Hilfe des Empfangsspulentabletts 1, an welchem die Bezugsspulen befestigt sind, getrennt erfaßt werden.

Wird diese Anordnung mit einem MEG-Magnetometer kombiniert, so ist es möglich, automatisch die Position und die Orientierung des MEG-Magnetometers zu bestimmen.

## Patentansprüche

1. Anordnung zur Bestimmung der räumlichen Position eines gegenüber einem Bezugselement (1) räumlich verschiebbaren Abtastelements (3),
- mit drei im Abtastelement (3) angeordneten, aus mindestens einer Drahtwindung bestehenden Raum-Spulen (4,5,6), welche um einen gemeinsamen Mittelpunkt (7) gewickelt sind,
- mit mindestens drei im Bezugselement (1) an räumlich voneinander entfernten Stellen angeordneten, aus mindestens einer Drahtwindung bestehenden Bezugs-Spulen (2),
- mit einem Stromgenerator (11) zur Erregung der Raum-Spulen (4,5,6) oder der Bezugs-Spulen (2) mit einem vorgebbaren Erreger-Wechselstrom,
- mit einer Auswerteschaltung (15) für die in den Bezugs-Spulen (2) bzw. in den Raum-Spulen (4,5,6) induzierten Spannungen, welche eine Rechenschaltung enthält, welche aus den induzierten Spannungen die Abstandskoordinaten xₘ, yₘ und zₘ des Mittelpunktes (7) der Raum-Spulen (4,5,6) in einem mit dem Bezugselement (1) verbundenen Koordinatensystem errechnet, sowie
- mit einer Rückkopplungsschaltung (13), welche in Abhängigkeit der Amplitude der induzierten Spannungen die Erregerströme steuert.

2. Anordnung nach Anspruch 1,
dadurch gekennzeichnet, daß die Wicklungsachsen der Raum-Spulen (4,5,6) in zueinander senkrechten Richtungen angeordnet sind.

3. Anordnung nach Anspruch 1 oder 2,
dadurch gekennzeichnet, daß die induzierten Spannungen über einen frequenz- und/oder phasenempfindlichen, mit dem Stromgenerator gekoppelten Verstärker (10) an die Auswerteschaltung (15) angeschlossen sind.

4. Anordnung nach einem der Ansprüche 1 bis 3,
dadurch gekennzeichnet, daß der Stromgenerator (11) über einen Multiplexer (12) an die als Erregerspulen dienenden Raum-Spulen (4,5,6) oder an die Bezugs-Spulen (2) angeschlossen ist, und daß die Erregerspulen mit Strömen gleicher Frequenz zeitlich aufeinanderfolgend erregbar sind.

5. Anordnung nach einem der Ansprüche 1 bis 3,
dadurch gekennzeichnet, daß die Erregerspulen gleichzeitig mit Erregerströmen verschiedener Frequenz vom Stromgenerator (11) betreibbar sind.

6. Anordnung nach einem der Ansprüche 1 bis 5,
dadurch gekennzeichnet, daß im Bezugselement (1) mindestens fünf Bezugsspulen (2) angeordnet sind, und daß die Auswerteschaltung (15) derart programmiert ist, daß auch die Winkellage des Abtastelements (3) berechenbar ist.

7. Anordnung nach Anspruch 6,
dadurch gekennzeichnet, daß die Auswerteschaltung (15) derart programmiert ist, daß zunächst die Koordinaten xₘ, yₘ und zₘ berechnet werden und danach zwei Winkelkoordinaten in zueinander senkrechten und durch den Mittelpunkt (7) der Raum-Spulen (4,5,6) verlaufenden Ebenen.
